(19) **Europäisches Patentamt**

**European Patent Office**

**Office européen des brevets**

(11) **EP 1 628 397 A1**

(12) **EUROPEAN PATENT APPLICATION**
published in accordance with Art. 158(3) EPC

(43) Date of publication:
**22.02.2006 Bulletin 2006/08**

(51) Int Cl.:
*H03H 17/02* (1980.01)   *H03H 17/04* (1980.01)
*H04R 3/00* (1968.09)

(21) Application number: **04733149.1**

(22) Date of filing: **14.05.2004**

(86) International application number:
**PCT/JP2004/006891**

(87) International publication number:
**WO 2004/107573 (09.12.2004 Gazette 2004/50)**

(84) Designated Contracting States:
**DE FR GB**

(30) Priority: **28.05.2003 JP 2003151417**

(71) Applicant: **MITSUBISHI DENKI KABUSHIKI KAISHA**
**Tokyo 100-8310 (JP)**

(72) Inventor: **Yano, Atsuyoshi**
**Chiyoda-ku,**
**Tokyo 100-8310 (JP)**

(74) Representative: **Pfenning, Meinig & Partner GbR**
**Mozartstrasse 17**
**80336 München (DE)**

(54) **AUDIO QUALITY ADJUSTMENT DEVICE**

(57)   A tone control apparatus is provided with a desired filter response input unit 11 for inputting a desired filter response into the tone control apparatus, a spectrum calculating unit 12 for calculating a Fourier spectrum for the set filter response which is inputted by the desired filter response input unit 11, a spectrum smoothing processing unit 13 for performing smoothing processing on the Fourier spectrum calculated by the spectrum calculating unit 12, a cepstrum calculating unit 14 for converting the Fourier spectrum smoothed by spectrum smoothing processing unit 13 into a cepstrum, and an LMA filter 15 to which the cepstrum calculated by the cepstrum calculating unit 14 is set as the filter factor of the LMA filter. The tone control apparatus also has an input terminal 16 for inputting a sound signal into the LMA filter 15, and an output terminal 17 for outputting a sound signal.

# FIG.1

**Description**

Field of the Invention

The present invention relates to a tone control apparatus provided with a digital filter.

Background of the Invention

There is a method of using a digital filter as a method of adjusting the tone quality of a sound signal. Either of an FIR (Finite Impulse Response) filter and an IIR (Infinite Impulse Response) filter is used as such a digital filter which constitutes a tone control filter.

It is necessary to design a desired filter response using a certain method when designing a tone control filter. For example, there are methods of representing the desired filter response as a Fourier spectrum, and computing a filter factor based on the Fourier spectrum. According to an example of such related art methods, an impulse response is obtained by carrying out an inverse Fourier transform of the Fourier spectrum, and the impulse response is then set as the filter factor of the tone control filter. According to this method, the filter factor can be easily calculated. As a filter provided with a filter factor which can be obtained in this way, there is an FIR filter, for example (refer to, for example, patent reference 1).

However, an FIR filter generally has a large amount of arithmetic operation and a large delay time, as compared with an IIR filter. On the other hand, an IIR filter can be formed as a filter with a relatively small size. While a typical IIR filter has a low degree of flexibility, it cannot necessarily have a desired filter characteristic. By the way, when designing an IIR filter based on a Fourier spectrum, the Fourier spectrum is converted into a cepstrum and a filter factor is determined from the cepstrum according to either of the following two types of methods.

One of them is a method of further converting the cepstrum, into which the Fourier spectrum has been converted, into a linear prediction coefficient (referred to as "LPC" from here on), and using the coefficient as the filter factor of the IIR filter (refer to, for example, patent reference 2). The other one is a filter which uses the cepstrum into which the Fourier spectrum has been converted as a coefficient, just as it is. This filter is known as a log magnitude approximation (referred to as "LMA" from here on) filter (refer to, for example, "Log magnitude approximation (LMA) filter" written by Satoshi Imai, Institute of Electronics and Communication Engineers of Japan paper magazine, vol. J63-A, No. 12, pp. 886 to 893, 1980).

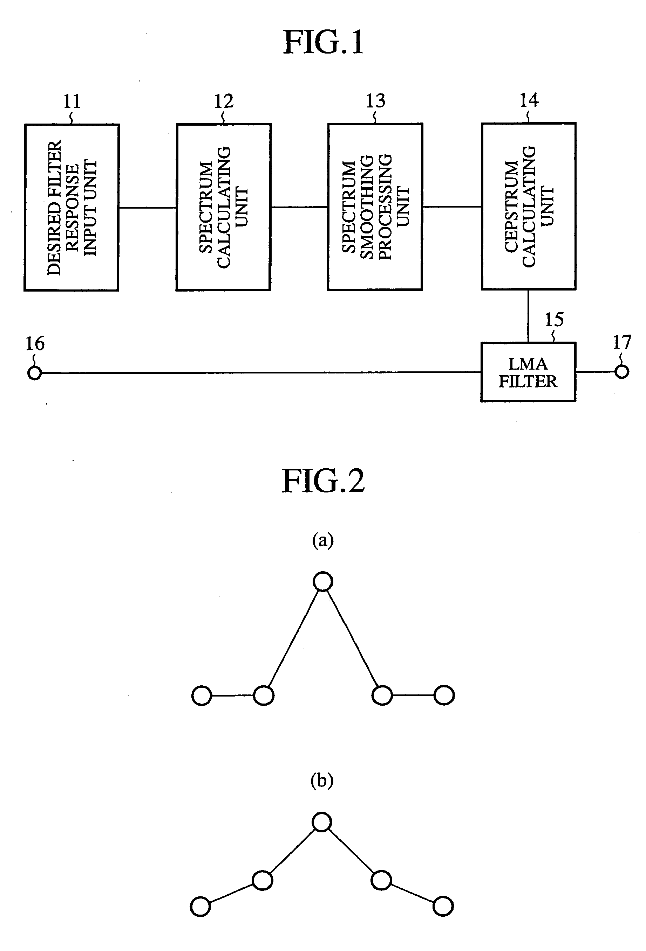

[Patent reference 1] JP,2-205106,A (Fig. 1)

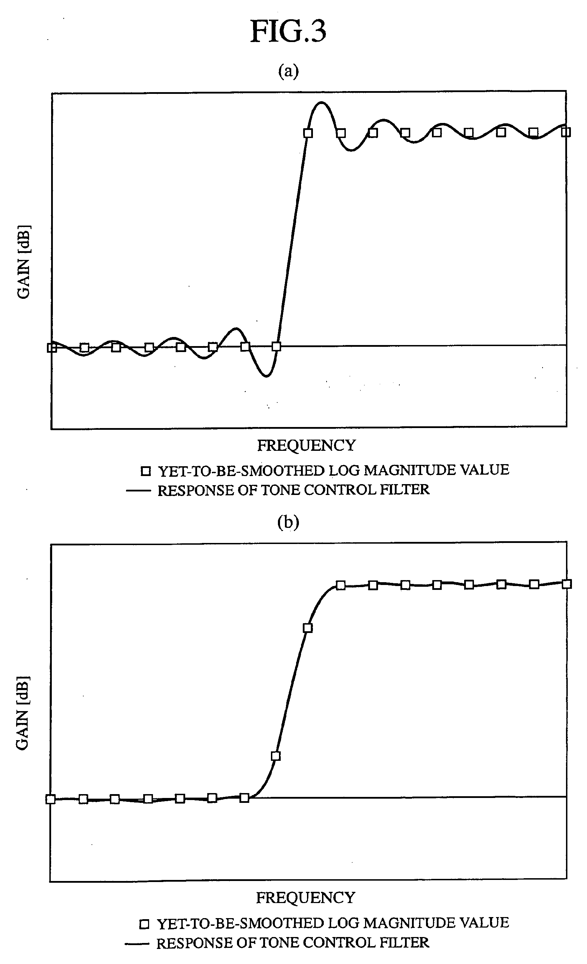

[Patent reference 2] JP,7-36484,A (pp. 58 to 65 and Fig. 3)

The LMA filter described in the above-mentioned paper has a high degree of flexibility in filter design, and a wide range of realizable filter responses. Furthermore, the LMA filter has a relatively small amount of arithmetic operation required for calculation of a filter factor thereof and filtering processing.

However, in a case of an IIR filter or an LMA filter having a filter factor which is an LPC coefficient to which a cepstrum as mentioned above is converted, a ripple which is contrary to a desired filter response may occur in the response characteristic of the filter which is actually formed. Particularly, when a steep characteristic change point, such as a sharp peak or dip, exists in the desired filter response, such a ripple appears notably and becomes a factor to reduce the accuracy of the tone control apparatus.

While setting of a long length of quefrency for the cepstrum can suppress such a ripple, the tone control filter increases in its hardware scale. On the other hand, when there is a limit on the hardware scale or the amount of arithmetic operation of the filter, it is difficult to increase the length of quefrency for the cepstrum.

The present invention is made in order to solve the above-mentioned problems, and it is therefore an object of the present invention to provide a tone control apparatus provided with a means for suppressing ripples with a fixed length of quefrency for the cepstrum.

Disclosure of the Invention

In accordance with the present invention, there is provided a tone control apparatus which constitutes a tone control filter having a desired characteristic by inputting a filter factor into said tone control filter, and which adjusts a sound signal by making the sound signal pass through said tone control filter, said tone control apparatus including a smoothing means for smoothing a Fourier spectrum of a desired filter response; a cepstrum calculating means for calculating a cepstrum from the Fourier spectrum smoothed by said smoothing means; and a filter factor calculating means for calculating said filter factor based on the cepstrum calculated by said cepstrum calculating means.

As a result, the tone control apparatus can suppress occurrence of ripples in the tone control filter and can provide high-precision tone control.

Brief Description of the Figures

Fig. 1 is a block diagram showing the structure of a tone control apparatus in accordance with embodiment 1 of the present invention;

Fig. 2 is a diagram for explaining a spectrum smoothing method which the tone control apparatus in accordance with embodiment 1 of the present invention uses;

Fig. 3 is a diagram for explaining an advantage provided by a smoothing method of smoothing a Fourier spectrum which a tone control apparatus in accordance with the present invention uses;

Fig. 4 is a diagram for explaining a spectrum smoothing method which the tone control apparatus in accordance with embodiment 2 of the present invention uses;

Fig. 5 is a diagram for explaining a spectrum smoothing method which the tone control apparatus in accordance with embodiment 3 of the present invention uses;

Fig. 6 is a flowchart for explaining the smoothing method spectrum smoothing method which the tone control apparatus in accordance with embodiment 3 of the present invention uses;

Fig. 7 is a block diagram showing the structure of a tone control apparatus in accordance with embodiment 4 of the present invention;

Fig. 8 is a block diagram showing the structure of a tone control apparatus in accordance with embodiment 5 of the present invention; and

Fig. 9 is the block diagram for explaining an analysis method of analyzing an input sound signal to obtain a spectral envelope, which the tone control apparatus in accordance with embodiment 5 of the present invention uses.

Preferred Embodiments of the Invention

Hereafter, in order to explain this invention in greater detail, the preferred embodiments of the present invention will be described with reference to the accompanying drawings.

Embodiment 1.

A tone control apparatus in accordance with embodiment 1 of the present invention will be explained hereafter with reference to Figs. 1 to 3. Fig. 1 is a block diagram showing the structure of the tone control apparatus in accordance with embodiment 1, Fig. 2 is a diagram for explaining a smoothing method of smoothing a Fourier spectrum, which this tone control apparatus uses, and Fig. 3 is a diagram for explaining an advantage provided by the smoothing method of smoothing a Fourier spectrum which the tone control apparatus uses.

This embodiment 1 is an example in which a desired filter response to the tone control apparatus is predetermined, and a filter factor of the tone control filter is calculated for the desired filter response. Assume that an LMA filter is used as the tone control filter in this embodiment.

As shown in Fig. 1, the tone control apparatus in accordance with embodiment 1 is provided with a desired filter response input unit 11 for inputting the desired filter response into the tone control apparatus, a spectrum calculating unit 12 for calculating a Fourier spectrum for the set filter response which is inputted by the desired filter response input unit 11, a spectrum smoothing processing unit 13 for performing smoothing processing on the Fourier spectrum calculated by the spectrum calculating unit 12, a cepstrum calculating unit 14 for converting the Fourier spectrum smoothed by spectrum smoothing processing unit 13 into a cepstrum, and an LMA filter 15 to which the cepstrum calculated by the cepstrum calculating unit 14 is set as the filter factor of the LMA filter. The tone control apparatus also has an input terminal 16 for inputting a sound signal into the LMA filter 15, and an output terminal 17 for outputting a sound signal from the LMA filter.

Next, the operation of the tone control apparatus will be explained.

The desired filter response is inputted into the desired filter response input unit 11. The filter response inputted into the desired filter response input unit 11 can take the form of the impulse response or a transfer function of a filter, or a gain function with frequency on the horizontal axis, for example. The spectrum calculating unit 12 converts the filter response inputted into the desired filter response input unit 11 into a Fourier spectrum given by the following equation (1):

$$H(e^{j2\pi k/N})(k=-N/2,\cdots,0,\cdots,N/2) \qquad (1)$$

The length N of the Fourier spectrum is equal to the length of quefrency of a cepstrum which will be explained below.

The calculated Fourier spectrum is smoothed by the spectrum smoothing processing unit 13. The smoothing of the Fourier spectrum can be done by filtering a series of sampled values of the Fourier spectrum using a median filter with a low pass characteristic. The smoothing using this method is given by the following equation (2):

$$S'(n) = \sum_{k=-N/2}^{N/2} S(k)W(n-k) \qquad (2)$$

In the above-mentioned equation (2), S(k) is the series of sampled values of the Fourier spectrum [equation (1)] which has not been smoothed yet, and W(n) is a coefficient sequence of the median filter which is used for the smoothing. Furthermore, S'(n) is the series of sampled values of the Fourier spectrum which has been smoothed. Fig. 2 shows this smoothing method, Fig. 2(a) shows yet-to-be-smoothed log magnitude values, and Fig. 2(b) shows smoothed log magnitude values.

The reason why a ripple may occur in the filter response of the tone control filter is that the tone control filter cannot follow a steep change in the Fourier spectrum of the desired filter response due to discontinuation of the cepstrum. The tone control apparatus can suppress the reverse effect by filtering the series of sampled values of the spectrum using the low pass filter. The tone control apparatus can perform this smoothing on either a power spectrum or a log square magnitude spectrum alternatively, instead of the simple Fourier spectrum.

Fig. 3 (a) shows the log square magnitude spectrum of the filter response of the tone control filter when the desired filter response has a shelving characteristic in which the gain of the filter increases rapidly at a certain frequency and the LMA filter is formed so as not to smooth the Fourier spectrum. Fig. 3(b) shows the log square magnitude spectrum of the response of the tone control filter at the time of smoothing the Fourier spectrum using the smoothing method shown by the equation (2).

The smoothed Fourier spectrum is then converted into a cepstrum according to the following equation (3) by the cepstrum calculating unit 14:

$$c(m) = \frac{1}{N} \sum_{k=-N/2}^{N/2} \ln S^2(k) e^{j2mk\pi/N} \qquad (3)$$

$m = 0,1,\cdots,N$

In the above-mentioned equation (3), c (m) is the cepstrum and m is the quefrency.

The cepstrum calculated by the cepstrum calculating unit 14 is used as the filter factor in the LMA filter 15. The transfer function of the LMA filter is defined by the following equation (4):

$$F(z) = \exp\left( \frac{c(0)}{2} + 2\sum_{m-1}^{M} c(m)z^{-m} \right) \qquad (4)$$

It is impossible to implement a filter circuit with the transfer function of exponential function type as shown in the equation (3). Therefore, the transfer function is developed into a form with which a filter circuit can be implemented according to a predetermined method of approximating an exponential function with a rational polynomial using modified Pade approximation. The predetermined method is described by, for example, "Speech signal processing" written by Satoshi Imai, Morikita Shuppan Co., Ltd., pp. 144 to 148, 1996.

Assume that the above-mentioned processing is carried out before a sound signal is input into the input terminal 16. The above-mentioned cepstrum can be calculated for each of two or more desired filter responses, and any one of the cepstrums thus calculated can be selected at the time when the tone control apparatus is used. The sound signal is inputted into the LMA filter 15 to which the cepstrum calculated by the cepstrum calculating unit 14 is set as the filter factor of the LMA filter via the input terminal 16, and the sound signal filtered by the LMA filter 15 is outputted via the output terminal 17.

Therefore, the tone control apparatus in accordance with this embodiment 1 can suppress ripples of the tone control filter and can make the tone control filter be faithful to the desired filter response by performing smoothing processing on a Fourier spectrum of the desired filter response, thereby providing high-precision tone control.

Since the tone control apparatus in accordance with this embodiment 1 uses a median filter with a low pass characteristic for the smoothing processing, it can perform the smoothing processing with a small amount of arithmetic operation.

Since the means for calculating the filter factor and the tone control filter can be independently formed by calculating the filter factor in advance before the sound signal is inputted to the tone control filter, the size of the tone control apparatus can be reduced.

In addition, since the tone control apparatus uses the LMA filter as the tone control filter, the tone control apparatus can be scaled down in size and can have a high degree of flexibility in design.

Embodiment 2.

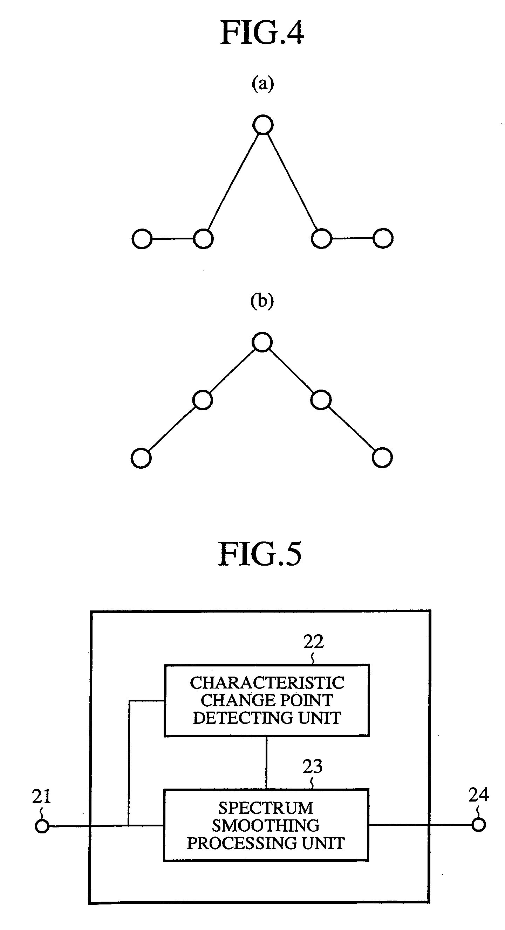

A tone control apparatus in accordance with embodiment 2 of the present invention will be explained hereafter with reference to Fig. 4. Fig. 4 is a diagram for explaining a smoothing method of smoothing a spectrum which the tone control apparatus in accordance with embodiment 2 uses.

Instead of the median filter with a low pass characteristic, which is disposed as the spectrum smoothing method in accordance with above-mentioned embodiment 1, the tone control apparatus in accordance with this embodiment 2 uses a method of replacing each odd or even-numbered sampled value of spectrum data as shown in Fig. 4 with an average of two sampled values adjacent to each odd or even-numbered sampled value. The other components and these components' workings of the tone control apparatus in accordance with embodiment 2 are the same as those explained in embodiment 1, and therefore the explanation of the other components and these components' workings will be omitted hereafter.

The smoothing method which the tone control apparatus in accordance with this embodiment 2 uses is represented by the following equation (5):

$$S'(2k+1) = \frac{1}{2}\left(S'(2k) + S(2k+2)\right)$$
$$S'(2k) = S(2k) \qquad\qquad\qquad\quad \Bigg\} \qquad (5)$$

In this equation (5), S(k) is an amplitude component of the Fourier spectrum which has not been smoothed yet, and S' (k) is an amplitude component of the Fourier spectrum which has been smoothed. As an alternative, S(k) can be either a power spectrum or a log square magnitude spectrum. The smoothed Fourier spectrum is inputted into a cepstrum calculating unit 14 of Fig. 1. Fig. 4(a) shows the log magnitude of the yet-to-be-smoothed Fourier spectrum, and Fig. 4(b) shows the logarithmic magnitude of the smoothed Fourier spectrum in which each odd or even-numbered sampled value of the spectrum data is replaced by an average of two sampled values adjacent to each odd or even-numbered sampled value.

Since the tone control apparatus in accordance with this embodiment 2 can smooth the Fourier spectrum of the desired filter response while maintaining the gain of the filter at a peak and a dip of the desired filter response, the tone control apparatus can provide a filter response in which ripples are suppressed without spoiling the peak and dip of the desired filter response, thereby enhancing the effects of the tone control apparatus.

Embodiment 3.

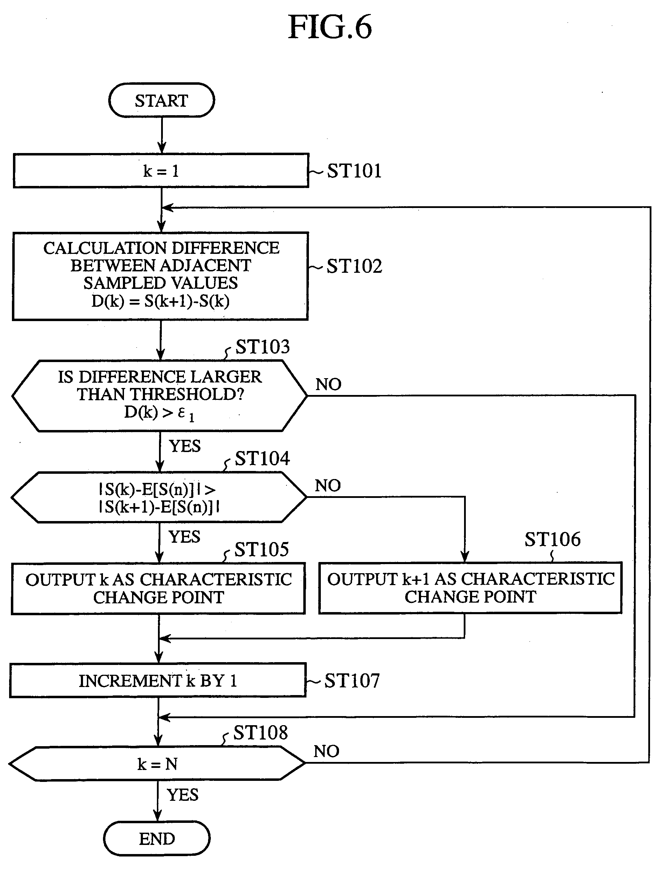

A tone control apparatus in accordance with embodiment 3 of the present invention will be explained hereafter with reference to Figs. 5 and 6. Fig. 5 is a diagram for explaining a spectrum smoothing method which the tone control apparatus in accordance with embodiment 3 of the present invention uses, and Fig. 6 is a flowchart for explaining the spectrum smoothing method which the tone control apparatus in accordance with embodiment 3 of the present invention uses.

Although the tone control apparatus in accordance with either of above-mentioned embodiments 1 and 2 performs the smoothing processing on a Fourier spectrum of a desired filter response over an entire frequency range, a ripple which occurs in the tone control filter substantially results from a steep change in the filter characteristic of the tone control filter, such as a peak and a dip which appears in the Fourier spectrum. Therefore, the tone control apparatus in accordance with this embodiment 3 does not smooth the Fourier spectrum of the desired filter response over the entire frequency range which is supported by the tone control filter, but smoothes only a frequency range of the Fourier spectrum which includes a steep change causing ripples. The other components and these components' workings of the tone control apparatus in accordance with this embodiment are the same as those explained in embodiment 1, and therefore the explanation of the other components and these components' workings will be omitted hereafter.

As shown in Fig. 5, in order to implement the spectrum smoothing method, the tone control apparatus in accordance with this embodiment includes a characteristic change point detecting unit 22 for detecting a change point where the filter characteristic of the tone control filter change steeply from the Fourier spectrum inputted via a spectrum input terminal 21, and a spectrum smoothing processing unit 23 for smoothing the Fourier spectrum inputted via the spectrum input terminal 21 based on the change point detected by the characteristic change point detecting unit 22. The tone control apparatus in accordance with this embodiment outputs the smoothed Fourier spectrum via a spectrum output terminal 24. The smoothed Fourier spectrum is then inputted into a cepstrum calculating unit 14 shown in Fig. 1.

Next, a method of detecting a change point where the filter characteristic of the tone control filter change steeply from the Fourier spectrum will be explained with reference to the flowchart of Fig. 6.

First, k = 1 is set for the inputted Fourier spectrum S(n), where n= 0, ..., N (in step ST101), and the difference D(k) between S(k), where n=k, and S(k+1) adjacent to S(k) is calculated according to equation (6) (in step ST102). As an alternative, S(n) can be either a power spectrum or a log square magnitude spectrum.

$$D(k) = S(k+1) - S(k) \qquad (6)$$

The characteristic change point detecting unit then determines whether $D(k) > \varepsilon_1$, where $\varepsilon_1$ is a threshold provided beforehand (in step ST103). When, in step ST103, determining that D(k) is larger than the threshold (i.e., if YES), the characteristic change point detecting unit determines whether or not a condition defined by equation (7) is satisfied, where E[S (n)] is an average value of summation of S(n), n= 0, ..., N (in step ST104).

$$\left| S(k) - E[S(n)] \right| > \left| S(k+1) - E[S(n)] \right| \qquad (7)$$

When the equation (7) is satisfied (i.e., if YES), the characteristic change point detecting unit outputs a current frequency point k as a characteristic change point (in step ST105). On the other hand, when the equation (7) is not satisfied (i.e., if NO), the characteristic change point detecting unit detects a frequency point k+1 as a characteristic, change point (in step ST106), increments k by 1 (in step ST107), and then determines whether or not k is equal to N (in step ST108). When, in step ST108, determining that k = N (i.e., if YES), the characteristic change point detecting unit ends the detection of a change point where the filter characteristic of the tone control filter change steeply from the Fourier spectrum. On the other hand, when, in step ST108, determining that k is not equal to N (i.e., if NO), the characteristic change point detecting unit returns to step ST102 in which it repeats the above-mentioned processing.

When, in step ST103, determining that D(k) does not exceed the threshold (i.e., if NO), the characteristic change point detecting unit advances to step ST108 in which it further determines whether or not k is equal to N. When, in step ST108, determining that k = N (i.e., if YES), the characteristic change point detecting unit ends the detection of a change point where the filter characteristic of the tone control filter change steeply from the Fourier spectrum. On the other hand, when determining that k is not equal to N (i.e., if NO), the characteristic change point detecting unit returns to step ST102 in which it repeats the above-mentioned processing.

The spectrum smoothing processing unit 23 then performs the smoothing processing, which is explained in embodiment 1 or 2, only on a fixed frequency range of the Fourier spectrum with a center frequency being equal to the characteristic change point detected as explained above.

As previously mentioned, since the tone control apparatus in accordance with this embodiment 3 detects a steep change point of the spectrum which causes a ripple, and then performs the smoothing processing only on a certain frequency range of the Fourier spectrum with a center frequency being equal to the change point detected, the tone control apparatus can reduce the amount of change in the Fourier spectrum caused by the smoothing to a minimum, and can make the tone control filter be faithful to the desired filter response, thereby providing high-precision tone control.

Embodiment 4.

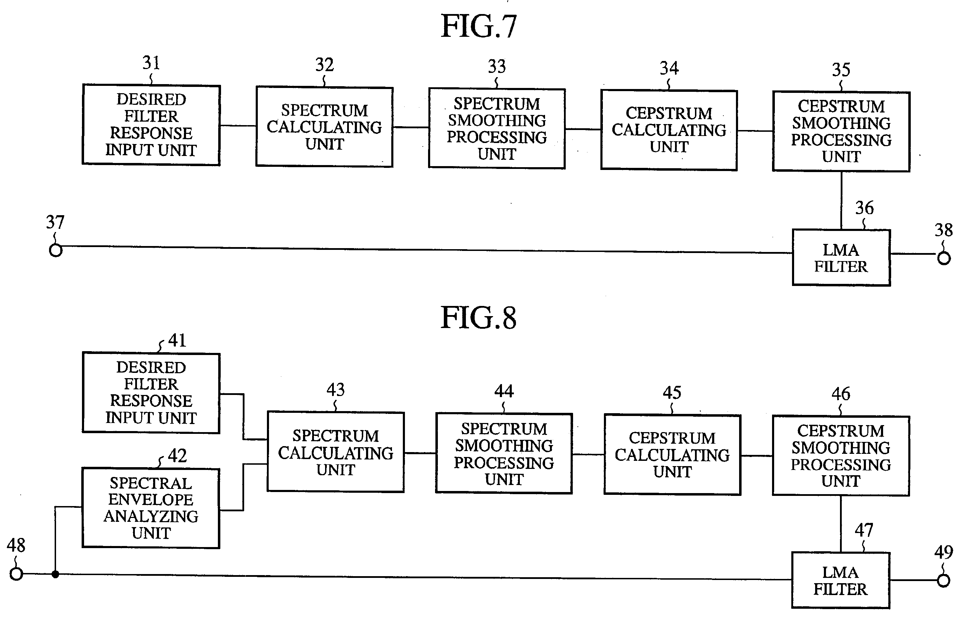

A tone control apparatus in accordance with embodiment 4 of the present invention will be explained hereafter with reference to Fig. 7. Fig. 7 is a block diagram showing the structure of the tone control apparatus in accordance with embodiment 4.

In accordance with above-mentioned embodiment 1, the filter factor is calculated before the sound signal is inputted into the tone control apparatus, and this filter factor is fixedly used by the tone control filter. In contrast, the tone control apparatus in accordance with this embodiment 4 accepts input of a desired filter response and updates the filter factor of the tone control filter sequentially according to the change of the desired filter response while a sound signal is inputted thereinto. The other components and these components' workings of the tone control apparatus in accordance with this embodiment are the same as those explained in embodiment 1, and therefore the explanation of the other components and these components' workings will be omitted hereafter.

As shown in Fig. 7, the tone control apparatus in accordance with embodiment 4 is provided with a desired filter response input unit 31 for inputting a desired filter response into the tone control apparatus, a spectrum calculating unit 32 for calculating a Fourier spectrum of the desired filter response inputted by the desired filter response input unit 31, a spectrum smoothing processing unit 33 for performing smoothing processing on the Fourier spectrum calculated by the spectrum calculating unit 32, a cepstrum calculating unit 34 for converting the Fourier spectrum smoothed by the spectrum smoothing processing unit 33 into a cepstrum, a cepstrum smoothing processing unit 35 for asymptotically updating another cepstrum which is to be provided to the tone control filter based on the cepstrum calculated by the cepstrum calculating unit 34, and an LMA filter 36 to which the cepstrum updated by the cepstrum smoothing processing unit 35 is set as the filter factor of the LMA filter. The tone control apparatus in accordance with embodiment 4 also has an input terminal 37 for inputting a sound signal into the LMA filter 36, and an output terminal 38 for outputting the sound signal.

Next, the operation of the tone control apparatus in accordance with this embodiment of the present invention will be explained.

A desired filter response of the tone control filter is inputted by the desired filter response input unit 31. The spectrum calculating unit 32 calculates a spectrum of the response inputted by the desired filter response input unit 31. The spectrum calculated can be a Fourier spectrum, or can be alternatively a power spectrum or a log square magnitude spectrum. The spectrum smoothing processing unit 33 smoothes the Fourier spectrum calculated by the spectrum calculating unit 32 using the spectrum smoothing method explained in either of above-mentioned embodiments 1 to 3. The smoothed spectrum is then converted into a cepstrum by the cepstrum calculating unit 34. The cepstrum calculated by the cepstrum calculating unit 34 is inputted into the cepstrum smoothing processing unit 35, and the cepstrum smoothing processing unit 35 updates the filter factor of the LMA filter 36 asymptotically according to the following equation (8):

$$C(m,t) = a \times C(m,t-1) + (1-a) \times c(m,t) \qquad (8)$$

where, $0<a<1$

In the equation (8), m is quefrency, t is a time, $c(m,t)$ is the cepstrum calculated by the cepstrum calculating unit 34, and $C(m, t)$ is the filter factor which is to be provided to the LMA filter 36.

Since the tone control apparatus in accordance with this embodiment 4 allows input of a desired filter response thereinto while the sound signal is inputted thereinto, users can arbitrarily change and adjust the tone quality of the sound signal while listening to the sound.

Since the tone control apparatus in accordance with this embodiment 4 is provided with the means for smoothing a spectrum of the desired filter response, the tone control apparatus can always suppress ripples of the tone control filter and can provide stable tone control even if the desired fil ter response varies from moment to moment.

Since the tone control apparatus in accordance with this embodiment 4 is further provided with the means for updating the filter factor asymptotically, the tone control apparatus can change the tone quality of the sound signal smoothly without causing the user who is listening the output sound to get a feeling that something is wrong even if the desired filter response inputted to the tone control apparatus is arbitrarily changed.

Embodiment 5.

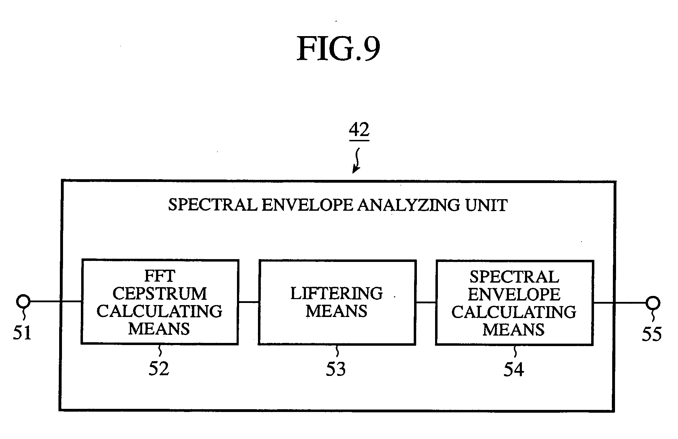

A tone control apparatus in accordance with embodiment 5 of the present invention will be explained hereafter with reference to Figs. 8 and 9. Fig. 8 is a block diagram showing the structure of a tone control apparatus in accordance with embodiment 5, and Fig. 9 is a block diagram for explaining an analysis method of analyzing an input sound signal to obtain a spectral envelope, which the tone control apparatus in accordance with this embodiment uses.

The tone control apparatus in accordance with above-mentioned embodiment 4 accepts a desired filter response from outside the tone control apparatus. In contrast, the tone control apparatus in accordance with this embodiment 5 analyzes a sound signal inputted thereinto so as to determine a desired filter response based on the analysis result depending on a given purpose. For example, the tone control apparatus can be so constructed as to calculate a spectrum of the sound signal inputted thereinto, analyze the spectrum of the sound signal so as to obtain a spectral envelope, and determine a filter response so as to emphasize this spectral envelope.

The tone control apparatus in accordance with embodiment 5 is an example of emphasizing the spectral envelope of the inputted sound signal, and, as shown in Fig. 8, is provided with a desired filter response input unit 41 for inputting a desired filter response into the tone control apparatus, a spectral envelope analyzing unit 42 for analyzing the inputted sound signal so as to obtain a spectral envelope, a spectrum calculating unit 43 for calculating a Fourier spectrum of a filter response of a tone control filter based on the desired filter response inputted by the desired filter response input unit 41, and the analysis result obtained by the spectral envelope analyzing unit 42, a spectrum smoothing processing unit 44 for performing smoothing processing on the Fourier spectrum calculated by the spectrum calculating unit 43, a cepstrum calculating unit 45 for converting the Fourier spectrum smoothed by the spectrum smoothing processing unit 44 into a cepstrum, a cepstrum smoothing processing unit 46 for updating a cepstrum which is to be provided to the tone control filter asymptotically based on the cepstrum calculated by the cepstrum calculating unit 45, and an LMA filter 47 to which the cepstrum updated by the cepstrum smoothing processing unit 46 is set as the filter factor of the LMA filter. The tone control apparatus in accordance with embodiment 5 also has an input terminal 48 for inputting a sound signal into the LMA filter 47, and an output terminal 49 for outputting the sound signal.

Next, the operation of the tone control apparatus in accordance with this embodiment of the present invention will be explained.

A desired filter response of the tone control filter is inputted into the desired filter response input unit 41. The spectral envelope analyzing unit 42 analyzes a sound signal inputted into the input terminal 48 so as to obtain a spectral envelope. The spectrum calculating unit 43 calculates a filter response of the tone control filter based on the desired filter response inputted by the desired filter response input unit 41 and the spectral envelope obtained by the spectral envelope analyzing unit 42.

The filter response of the tone control filter is calculated according to equation (9). Equation (10) in the equation (9) shows the Fourier spectrum of the desired filter response inputted into the desired filter response input unit 41, equation (11) shows the spectral envelope obtained by the spectral envelope analyzing unit 42, and equation (12) shows the Fourier spectrum outputted from the spectrum calculating unit 43. $\alpha$ is a constant and is a parameter for controlling the degree of enhancement of the spectral envelope. The spectrum calculated can be alternatively a power spectrum or a log square magnitude spectrum.

$$H_{filter}(e^{j2\pi k/N}) = \alpha \times H_{in}(e^{j2\pi k/N}) \times H_{env}(e^{j2\pi k/N}) \qquad (9)$$

$$H_{in}(e^{j2\pi k/N}) \qquad (10)$$

$$H_{env}(e^{j2\pi k/N}) \qquad (11)$$

$$H_{filter}\left(e^{j2\pi k/N}\right) \qquad (1\ 2)$$

The spectrum smoothing processing unit 44 smoothes the Fourier spectrum calculated by the spectrum calculating unit 43 using the spectrum smoothing method explained in either of above-mentioned embodiments 1 to 3. The smoothed spectrum is then converted into a cepstrum by the cepstrum calculating unit 45. The cepstrum calculated by the cepstrum calculating unit 45 is inputted into the cepstrum smoothing processing unit 46, and the cepstrum smoothing processing unit 46 updates the filter factor of the LMA filter 47 asymptotically according to the method explained in above-mentioned embodiment 4.

Next, the analysis processing performed by the spectral envelope analyzing unit 42 will be explained. The sound signal inputted, via the input terminal 48, into the spectral envelope analyzing unit 42 of Fig. 8 in units of frames is converted into an FFT cepstrum by an FFT cepstrum calculating means 52. The FFT cepstrum is calculated according to the following equation (13). The input terminal 48 corresponds to an input terminal 51 of Fig. 9.

$$c_{fft}(n) = \frac{1}{N}\sum_{k=-N/2}^{N/2}\ln|X(k)|e^{j2kn\pi/N} \qquad (1\ 3)$$

In this equation (13), $C_{fft}(n)$ is the FFT cepstrum of the incoming sound signal, and $X(k)$ is the Fourier spectrum of the incoming sound signal.

A liftering means 53 performs liftering on the FFT cepstrum so that high-quefrency components of the FFT cepstrum are cancelled and low-quefrency components of the FFT cepstrum are left. A spectral envelope calculating means 54 acquires a spectral envelope by performing FFT on the FFT cepstrum, on which the liftering has been performed, again. The spectral envelope acquired as mentioned above is outputted from an output terminal 55, and is then inputted into the spectrum calculating unit 43 of Fig. 8.

Since the tone control apparatus in accordance with this embodiment 5 has the means for analyzing the spectral envelope of the input sound signal in units of frames so as to emphasize the spectral envelope, the tone control apparatus can make the sound signal clear.

In addition, since the tone control apparatus is provided with the means for smoothing the spectrum of the filter response, it can always suppress ripples of the tone control filter even when the target filter response varies from moment to moment dependently upon changes in the sound signal with time, thereby providing stable tone control.

Embodiment 6.

A tone control apparatus in accordance with embodiment 6 of the present invention will be explained hereafter. The tone control apparatus in accordance with either of above-mentioned embodiments 1 and 4 uses an LMA filter as the tone control filter. The tone control apparatus in accordance with this embodiment 6 uses, as the tone control filter, an IIR filter having a filter factor which is an LPC coefficient calculated from a cepstrum. The other components and these components' workings of the tone control apparatus in accordance with this embodiment are the same as those explained in embodiment 1, and therefore the explanation of the other components and these components' workings will be omitted hereafter.

In this case, the filter factor is acquired according to the following equation (14):

$$\left.\begin{array}{l} a(1) = -c(1) \\ a(n) = -c(n) - \sum_{m=1}^{n-1}\left(1-\dfrac{m}{n}\right)a(m)c(n-m) \qquad (1 < n \le p) \end{array}\right\}$$

$$(1\ 4)$$

In the above-mentioned equation (14), a(n) is the LPC coefficient and p is the order of the IIR filter.

A transfer function F(z) of the IIR filter which is the tone control filter is given by the following equation (15):

$$F(z) = \frac{1}{1 + \sum_{k=1}^{p} a(k)z^{-k}} \qquad (15)$$

Since the tone control apparatus in accordance with this embodiment 6 uses a common IIR filter as the tone control filter, the tone control apparatus can be scaled down in size and can have a small amount of arithmetic operation.

Industrial Applicability

As mentioned above, the tone control apparatus in accordance with the present invention is suitable for tone control using a digital filter.

**Claims**

1. A tone control apparatus which constitutes a tone control filter having a desired characteristic by inputting a filter factor into said tone control filter, and which adjusts a sound signal by making the sound signal pass through said tone control filter, **characterized in that** said tone control apparatus comprises:

   a smoothing means for smoothing a Fourier spectrum of a desired filter response;
   a cepstrum calculating means for calculating a cepstrum from the Fourier spectrum smoothed by said smoothing means; and
   a filter factor calculating means for calculating said filter factor based on the cepstrum calculated by said cepstrum calculating means.

2. The tone control apparatus according to Claim 1, **characterized in that** the filter factor inputted to the tone control filter is a fixed filter factor calculated in advance.

3. The tone control apparatus according to Claim 1, **characterized in that** said apparatus includes a means for allowing a change of the desired filter response and for updating said filter factor successively according to said change of the desired filter response while the sound signal is inputted into the tone control filter.

4. The tone control apparatus according to Claim 1, **characterized in that** said apparatus includes a means for determining the desired filter response based on a result of analysis of the sound signal while the sound signal is inputted into the tone control filter.

5. The tone control apparatus according to Claim 1, **characterized in that** said apparatus includes a means for smoothing the Fourier spectrum by filtering a series of sampled values of the Fourier spectrum with a low pass filter.

6. The tone control apparatus according to Claim 1, **characterized in that** said apparatus includes a means for smoothing the Fourier spectrum by replacing each odd or even-numbered sampled value of the Fourier spectrum with an average of sampled values adjacent to each odd or even-numbered sampled value.

7. The tone control apparatus according to Claim 1, **characterized in that** said apparatus includes a means for detecting a change point of the Fourier spectrum of the desired filter response, which changes steeply, and for smoothing a certain range of the Fourier spectrum with its center being at the change point.

8. The tone control apparatus according to Claim 1, **characterized in that** the tone control filter is a log magnitude approximation filter, and the cepstrum is set as the filter factor of the tone control filter.

9. The tone control apparatus according to Claim 1, **characterized in that** the tone control filter is an IIR filter, and a linear prediction coefficient to which the cepstrum is converted is set as the filter factor of the tone control filter.

# FIG.1

# FIG.2

(a)

(b)

# FIG.3

(a)

FREQUENCY

□ YET-TO-BE-SMOOTHED LOG MAGNITUDE VALUE
—— RESPONSE OF TONE CONTROL FILTER

(b)

FREQUENCY

□ YET-TO-BE-SMOOTHED LOG MAGNITUDE VALUE
—— RESPONSE OF TONE CONTROL FILTER

# FIG.4

(a)

(b)

# FIG.5

CHARACTERISTIC
CHANGE POINT
DETECTING UNIT
22

SPECTRUM
SMOOTHING
PROCESSING UNIT
23

21

24

# FIG.6

```
          ┌──────────┐
          │  START   │
          └──────────┘
                │
                ▼
  ┌─────────────────────────┐
  │          k = 1          │ ~ST101
  └─────────────────────────┘
                │
                ▼
  ┌─────────────────────────┐
  │  CALCULATION DIFFERENCE  │
  │   BETWEEN ADJACENT       │ ~ST102
  │    SAMPLED VALUES        │
  │  D(k) = S(k+1)-S(k)      │
  └─────────────────────────┘
                │
                ▼            ST103
       ╱─────────────────╲
      ╱  IS DIFFERENCE     ╲        NO
     ╱   LARGER THAN        ╲──────────
     ╲   THRESHOLD?         ╱
      ╲  D(k) > ε₁         ╱
       ╲─────────────────╱
                │ YES
                ▼            ST104
       ╱─────────────────╲
      ╱  |S(k)-E[S(n)]| >  ╲        NO
      ╲  |S(k+1)-E[S(n)]|  ╱──────────
       ╲─────────────────╱
                │ YES
                ▼        ST105
```

IS DIFFERENCE LARGER THAN THRESHOLD?
$D(k) > \varepsilon_1$

$|S(k)-E[S(n)]| > |S(k+1)-E[S(n)]|$

ST105: OUTPUT k AS CHARACTERISTIC CHANGE POINT

ST106: OUTPUT k+1 AS CHARACTERISTIC CHANGE POINT

ST107: INCREMENT k BY 1

ST108: k = N

NO / YES

END

# FIG.7

| 31 | 32 | 33 | 34 | 35 |
|---|---|---|---|---|
| DESIRED FILTER RESPONSE INPUT UNIT | SPECTRUM CALCULATING UNIT | SPECTRUM SMOOTHING PROCESSING UNIT | CEPSTRUM CALCULATING UNIT | CEPSTRUM SMOOTHING PROCESSING UNIT |

37 ○ ————————————————————————— 36 | LMA FILTER | ○ 38

# FIG.8

| 41 | | | | |
|---|---|---|---|---|
| DESIRED FILTER RESPONSE INPUT UNIT | | | | |
| 42 | 43 | 44 | 45 | 46 |
| SPECTRAL ENVELOPE ANALYZING UNIT | SPECTRUM CALCULATING UNIT | SPECTRUM SMOOTHING PROCESSING UNIT | CEPSTRUM CALCULATING UNIT | CEPSTRUM SMOOTHING PROCESSING UNIT |

48 ○ ————————————————————————— 47 | LMA FILTER | ○ 49

EP 1 628 397 A1

# FIG.9

<u>42</u>

| | SPECTRAL ENVELOPE ANALYZING UNIT | |
|---|---|---|
| FFT CEPSTRUM CALCULATING MEANS | LIFTERING MEANS | SPECTRAL ENVELOPE CALCULATING MEANS |
| 52 | 53 | 54 |

51                                                                 55

## INTERNATIONAL SEARCH REPORT

| | International application No. |
|---|---|
| | PCT/JP2004/006891 |

| A. | CLASSIFICATION OF SUBJECT MATTER |
|---|---|
| | Int.Cl⁷  H03H17/02, H03H17/04, H04R3/00 |

According to International Patent Classification (IPC) or to both national classification and IPC

| B. | FIELDS SEARCHED |
|---|---|

Minimum documentation searched (classification system followed by classification symbols)
Int.Cl⁷  H03H17/00-17/08, H04R3/00

Documentation searched other than minimum documentation to the extent that such documents are included in the fields searched

| Jitsuyo Shinan Koho | 1922–1996 | Toroku Jitsuyo Shinan Koho | 1994–2004 |
|---|---|---|---|
| Kokai Jitsuyo Shinan Koho | 1971–2004 | Jitsuyo Shinan Toroku Koho | 1996–2004 |

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y<br>A | JP 7-36484 A  (Sharp Corp.),<br>07 February, 1995 (07.02.95),<br>Par. Nos. [0058] to [0065]; Fig. 1<br>(Family: none) | 1-5,7-9<br>6 |
| Y<br>A | JP 9-261005 A  (NEC Corp.),<br>03 October, 1997 (03.10.97),<br>Par. Nos. [0002] to [0005]; Fig. 3<br>(Family: none) | 1-5,7-9<br>6· |
| Y | JP 2-108318 A  (Matsushita Electric Industrial<br>Co., Ltd.),<br>20 April, 1990 (20.04.90),<br>Page 3, upper left column, line 17 to page 4,<br>upper right column, line 7; Fig. 1<br>(Family: none) | 3 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 12 August, 2004 (12.08.04) | 31 August, 2004 (31.08.04) |

| Name and mailing address of the ISA/<br>Japanese Patent Office | Authorized officer |
|---|---|
| Facsimile No. | Telephone No. |

Form PCT/ISA/210 (second sheet) (January 2004)

## INTERNATIONAL SEARCH REPORT

| International application No. |
| --- |
| PCT/JP2004/006891 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 6-315104 A  (Sony Corp.),<br>08 November, 1994 (08.11.94),<br>Par. No. [0019]; Fig. 1<br>(Family: none) | 7 |
| Y | JP 6-97772 A  (Toyo Communication Equipment Co., Ltd.),<br>08 April, 1994 (08.04.94),<br>Par. No. [0002]; Figs. 1, 2<br>(Family: none) | 8 |

Form PCT/ISA/210 (continuation of second sheet) (January 2004)